# EUROPEAN PATENT SPECIFICATION

(11) **EP 1 885 917 B1**
(45) Date of publication and mention of the grant of the patent: **04.08.2010**
(21) Application number: 06777236.8
(22) Date of filing: 23.05.2006
(51) Int. Cl.: C30B 25/14, B01J 12/02, B01J 19/26

(54) **EPITAXIAL REACTOR WITH DEVICE FOR INTRODUCING REACTION GASES**
EPITAXIALREAKTOR MIT GERÄT ZUR EINFÜHRUNG VON REAKTIONSGASEN
REACTEUR EPITAXIAL AVEC DISPOSITIF PERMETTANT D'INTRODUIRE DES GAZ REACTIONNELS

(30) Priority: 25.05.2005 IT MI20050962
(43) Date of publication of application: 13.02.2008
(73) Proprietor: LPE SPA, I-20021 Bollate (MI) (IT)
(72) Inventor: POZZETTI, Vittorio, c/o LPE SPA, I-20021 Bollate (MI) (IT); SPECIALE, Natale, c/o LPE SPA, I-20021 Bollate (MI) (IT); VALENTE, Gianluca, c/o LPE SPA, I-20021 Bollate (MI) (IT); PRETI, Franco, c/o LPE SPA, I-20021 Bollate (MI) (IT)
(74) Representative: Dragotti, Gianfranco
(86) International application number: PCT/EP2006/062523
(87) International publication number: WO 2006/125777

(56) References cited:
- WO-A-99/43874
- US-A- 5 871 586
- US-A1- 2004 005 731
- PATENT ABSTRACTS OF JAPAN vol. 009, no. 205 (C-299), 22 August 1985 (1985-08-22) & JP 60 071596 A (MATSUSHITA DENKI SANGYO KK), 23 April 1985 (1985-04-23)
- PATENT ABSTRACTS OF JAPAN vol. 010, no. 235 (C-366), 14 August 1986 (1986-08-14) & JP 61 068393 A (TOUYOKO KAGAKU KK), 8 April 1986 (1986-04-08)
- PATENT ABSTRACTS OF JAPAN vol. 010, no. 292 (C-376), 3 October 1986 (1986-10-03) & JP 61 110767 A (FUJITSU LTD), 29 May 1986 (1986-05-29)
- PATENT ABSTRACTS OF JAPAN vol. 011, no. 249 (E-532), 13 August 1987 (1987-08-13) & JP 62 061317 A (TOSHIBA CORP), 18 March 1987 (1987-03-18)

## Description

The present invention relates to a device for introducing reaction gases into a reaction chamber and to an epitaxial reactor which uses said device.

As is known, epitaxial reactors are apparatus which are used to deposit layers of material onto a seed or a substrate in an ordered and uniform manner.

These apparatus are used to provide "slices" for the microelectronics industry which uses them in order to produce electrical components, in particular integrated circuits.

Epitaxial reactors have a reaction chamber which is kept at a high temperature during the epitaxial growth processes. Reaction gases are introduced inside the reaction chamber and react and form the material which is deposited epitaxially on the seed or on the substrate. The reaction gases and the temperature of the chamber depend mainly on the material to be deposited. For example, if silicon (chemical symbol Si) is deposited, the temperature may vary typically from 600°C to 1300°C, and if silicon carbide (chemical symbol SiC) is deposited, the temperature may vary typically from 1,500°C to 2,500°C.

At the abovementioned high temperatures the reaction gases dissociate when they are inside the reaction chamber.

However, it has been noted that the reaction gases tend to partially dissociate also before entry into the reaction chamber; this phenomenon depends on the reaction gases, on the design of the epitaxial reactor and on the temperatures inside the epitaxial reactor in particular inside the reaction chamber.

This dissociation may give rise to spurious depositions (for example silicon) along the gas pipes in particular in the vicinity of the reaction chamber and, with the passing of time, may also cause total occlusion of the pipes.

If the material to be deposited is not a chemical element (for example silicon or germanium), but is a chemical compound (for example, gallium arsenide or silicon carbide or gallium nitride) produced by a chemical reaction between precursor gases, the dissociation of the precursor gases may give rise to liquid or solid particles of the material to be deposited (for example silicon carbide) which may be deposited and/or accumulate along the pipes.

The abovementioned phenomena may hinder the transportation of the chemical species for the epitaxial deposition process at the most suitable concentrations and temperatures and therefore reduce the efficiency of this process.

The patent application WO2004111316 describes an epitaxial reactor which is particularly suitable for the growth of silicon carbide ingots by means of epitaxial deposition at a very high temperature, typically between 2,000°C and 2,400°C. In this particular reactor, the carbon-containing reaction gases and the silicon-containing reaction gases are introduced into the reaction chamber in separate positions and via separate pipes.

US 2004/005731 to Jurgensen Holger et al discloses a device for depositing crystalline layers on one or more crystalline substrates in a process chamber by means of reaction gases which are introduced into the process chamber where they react pyrolytically. The device comprises a gas admission element by means of which at least two reaction gases are fed into the process chamber, such a gas admission element including a frustoconical-shaped end portion projecting into the process chamber and provided with a cooling-water chamber 49 designed to cool the gas admission element to a temperature which is lower than the decomposition temperature of the reaction gases.

JAP 60 071596 A to Matsushita Denki Sangyo KK of the Patent Abstracts of Japan vol. 009, no. 205 (C-299) discloses vapor-phase growth apparatus wherein a raw material is introduced into a growth chamber through an introduction pipe provided with a cooling pipe on the outer wall.

Inside a reactor for epitaxial deposition of silicon carbide at a very high temperature, the problem of premature dissociation of the reaction gases is particularly evident especially in the case of silicon-containing reaction gases, for example SiH4.

The general object of the present invention is to provide a solution to the problem of dissociation (in undesirable locations) of the reaction gases inside epitaxial reactors.

A more specific object of the present invention is to provide a solution to the problem of dissociation (in undesirable locations) of the silicon-containing reaction gases inside epitaxial reactors for epitaxial deposition of silicon carbide at a very high temperature.

These and other objects are achieved by means of the reactor having the characteristic features described in the claims attached hereto.

The idea forming the basis of the present invention is to cool properly the reaction gases before entry into the reaction chamber.

Generally, according to the present invention, the reaction gas is kept at a temperature lower than its dissociation temperature along the entire travel path from the reaction gas storage chamber to the reaction chamber; the most critical part of the travel path is that part in the vicinity of the reaction chamber which is very hot during the epitaxial deposition processes.

According to a further aspect, the present invention also relates to a method for introducing a reaction gas into a reaction chamber of an epitaxial reactor.

The present invention will emerge more clearly from the following description to be considered together with the accompanying drawings in which:
Fig. 1 shows a schematic cross-sectional view of a device used in a reactor according to the present invention;
Fig. 2A shows a schematic cross-sectional view of a first example of embodiment of a component of a device used in a reactor according to the present invention;
Fig. 2B shows a schematic cross-sectional view of a second example of embodiment of a component of a device used in a reactor according to the present invention; and
Fig. 3 shows a schematic cross-sectional view of a part of an epitaxial reactor according to the present invention.

Both this description and these drawings are to be regarded solely as examples and are therefore not limiting.

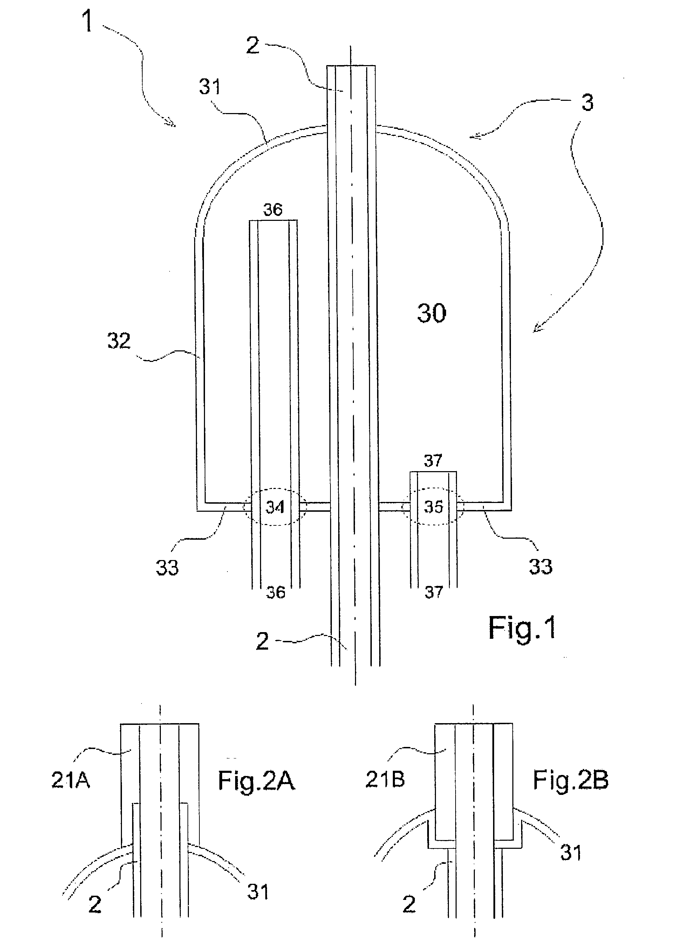

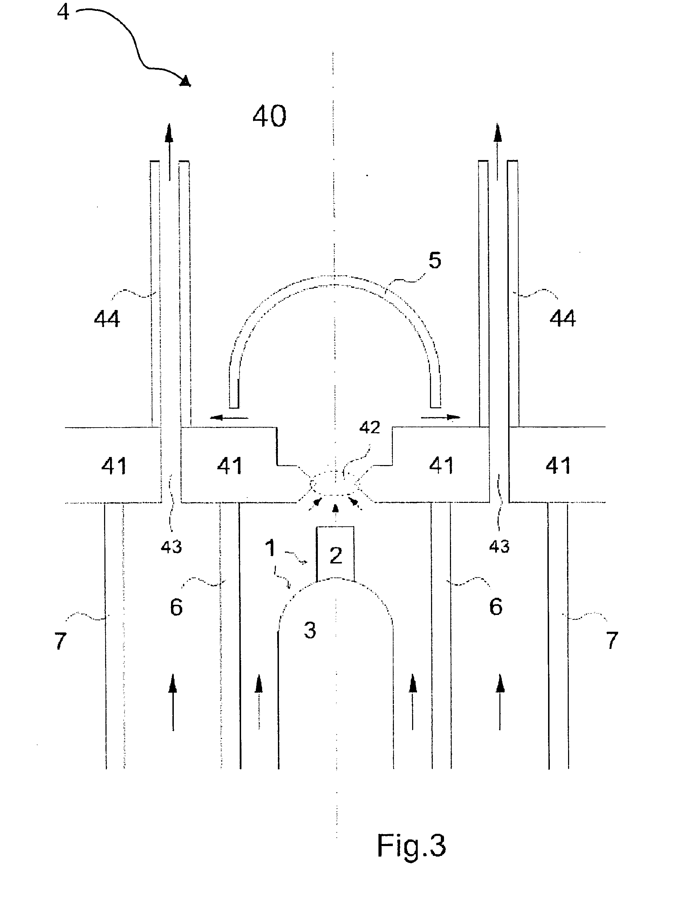

Fig. 1 shows an example of embodiment of a device, indicated overall by the reference number 1. This device 1 is shown partially also in Fig. 3 where it is inserted inside an epitaxial reactor 4 and has the function of introducing a reaction gas, in particular SiH4, into a reaction chamber 40.

The device 1 envisages a supply pipe, denoted by the reference number 2, for conveying a reaction gas, and a cooling member, denoted overall by the reference number 3.

In the example according to Fig. 1, the member 3 consists of a shell which delimits a cavity 30 with a cylindrical part 32 which terminates on a first side in a cover 31 and on a second side in a disk 33.

The pipe 2 extends inside and outside the shell 3, passing through the cover 31, in particular through its hole, and the disk 33, in particular through a hole therein. The cover 31 and the disk 33 are sealed on the pipe 2; since these parts are made typically of metal, the seal is typically achieved by means of welding and there is therefore no difficulty in ensuring a seal at high temperatures.

The disk 33 has an inlet opening 34 and an outlet opening 35; there is also a circulation pipe 36 connected to the opening 34 and extending far inside the shell 3 and a discharge pipe 37 which extends a small amount inside the shell 3. It is envisaged that a cooling fluid, for example hydrogen or water, enters into the cavity 30 of the shell 3 via the pipe 36, circulates inside the cavity 30 and emerges from the cavity 30 via the pipe 37.

In the example according to Fig. 1, the pipe 2 projects from the shell 3 by a small amount at the top, on the side where the cover 31 is situated, and by a large amount at the bottom, on the side where the disk 33 is situated.

According to a first variant of the example according to Fig. 1, the pipe 2 projects from the shell 3 by a very small amount at the top and a nozzle 21A is mounted on the pipe 2, as shown in Fig. 2A.

According to a second variant of the example according to Fig. 1, the pipe 2 does not project from the shell 3 at the top, and a nozzle 21B is mounted on the shell 3, in particular inside a recess of the cover 31, as shown in Fig. 2B; the pipe 2 emerges inside this recess.

Fig. 3 shows only a part of the reactor 4 which is an example of embodiment of an epitaxial reactor according to the present invention; the remainder of the reactor could be constructed, for example as can be seen in Fig. 3 of the patent application W02004111316.

In this figure, a wall 41 of the reaction chamber 40, in particular the bottom wall, is visible; the wall 41 has an opening 42 for entry of the silicon-containing reaction gas, in particular SiH4, and six openings 43 (only two of which are visible in the figure) for entry of the carbon-containing reaction gas, in general a hydrocarbon in the gaseous state, in particular C2H4 which has a low hydrogen content. It is necessary to take into account that the reaction gases are typically introduced into the reaction chamber mixed, for example, with hydrogen and/or helium and/or argon.

The wall 41 is shaped in a very particular manner in the region of the opening 42; there is a hole which has a double flaring, i.e. one on one side and one on the other side, and a recess, in particular with a substantially cylindrical shape and a diameter far greater than the diameter of the hole (for example twice the size).

Inside the chamber 40, in the region of the opening 42, there is a heating cell which is formed essentially by a dome 5; however, the recess of the wall 41 also acts as a heating cell; the heating cell is effective also for evaporating/sublimating any liquid/solid particles, in particular of silicon, which may have formed upstream of the said cell. The dome 5 communicates with the chamber 40 by means of openings situated, in particular, at the bottom of the dome, close or adjacent to the walls 41.

As can be noted in Fig. 3, the gases, in particular SiH4, emerge from the dome 5 hot, at a slow speed and in a direction substantially parallel to the wall 41; in this way the gases then rise up along the chamber 40 in a uniform manner and along the whole cross-section of the chamber 40.

Inside the chamber 40, in the vicinity of each of the openings 43, there is a flue-pipe 44; the carbon-containing reaction gas comes into contact with the silicon-containing reaction gas upon emerging from the flue-pipes 44 and therefore in a central zone of the reaction chamber 40; in the reactor according to Fig. 3 the silicon-containing reaction gas does not practically come into contact with free carbon before reaching the central zone of the reaction chamber 40 and therefore there is practically no formation of SiC, in particular solid particles of SiC, before this zone.

The device 1 is situated outside the chamber 40, in the vicinity of the opening 42; the device 1 is not in contact with the wall 41; an annular zone is defined between the top end of the device 1, in particular the top end of the pipe 2 and the wall 41.

The device 1 is surrounded by a first tube 6, but is not in contact with the latter; the tube 6 is closed at the top by the wall 41 and communicates with the chamber 40 by means of the abovementioned annular zone.

The first tube 6 is surrounded by a second tube 7, but is not in contact with the latter; the tube 7 is closed at the top by the wall 41 and communicates with the chamber 40 by means of the openings 43 and the flue-pipes 44.

In general, the device used in a reactor according to the present invention comprises:
- a gas supply pipe, and
- a cooling member situated at one end of the supply pipe and able to cool the supply pipe and thereby the gas flowing inside it.

It therefore consists of a cooled injection device; in this way, it is possible to avoid or limit greatly the dissociation of the reaction gas before it enters into the reaction chamber and therefore also any spurious depositions along the pipes. It is evident that the cooling member has the function of preventing the heat from the reaction chamber (mainly due to irradiation) from heating the reaction gases supplied from the corresponding tank via the appropriate piping and therefore helps to keep the reaction gas at a low enough temperature, namely higher than the storage temperature inside the tank and lower than the dissociation temperature.

This device has been designed for the gases which react inside the reaction chamber and which form the epitaxially deposited material, namely the precursor gases.

It is advantageous to envisage such a device for a single reaction gas and therefore provide inside the device a single supply pipe. In this way the temperature of the reaction gas may be adapted to the specific reaction gas used, the device may be arranged very close to the opening for entry of the specific reaction gas into the reaction chamber and therefore its temperature may be controlled until slightly before entry into the reaction chamber, and the device may be adapted to the configuration and to the temperature of the reaction chamber in the zone where the opening for entry of the specific reaction gas into the reaction chamber is situated.

The cooling member may be easily and effectively formed by means of a shell which surrounds one end of the supply pipe.

In this case, it is possible to envisage that the shell delimits a cavity and comprises means for allowing a cooling fluid to enter into, circulate inside and flow out from the cavity.

The cooling fluid may be gaseous or liquid; typically, a liquid fluid allows heat to be removed more quickly. The gases which may be used include: hydrogen, nitrogen, helium, argon or mixtures thereof. The liquids which may be used include primarily water; alternatively its is possible to use diathermic oils which withstand higher temperatures and may be used at high temperatures without creating a high pressure (water boils at a low temperature, generating vapour and therefore a high pressure inside the pipes).

An interesting possibility is to cool the cooling fluid before providing it to the device, particularly before making it to enter in the cavity of the device; in such a away, it is possible to cool more the gas flowing in the supply pipe; in this case, obviously, it is appropriate to check the flow rate and / or the temperature of the cooling fluid flow. The cooling flow can be cooled at a temperature lower than 0°C, in particular comprised between -50°C and -150°C; it is appropriate that such a temperature is chosen in order to avoid that the gas flowing in the supply pipe condense into it; For example in the case of silane (SiH4), it is appropriate that the cooling temperature of the cooling fluid is not lower than -110°C (condensation temperature of the silane). Nitrogen, for example, is a cooling fluid easily available and well adapted to be easily precooled.

In order to obtain circulation of the cooling fluid inside the cavity, it is possible to envisage at least one inlet opening and at least one outlet opening formed in the shell.

From a constructional point of view it is convenient for the shell to have substantially the shape of a cylinder and for the axis of the shell and the axis of the supply pipe to be substantially parallel; if the two axes substantially coincide, as in the example according to Fig. 1, cooling of the pipe is more uniform.

Advantageously, the shell may terminate on one side in a cover, in particular on the side suitable for positioning close to the inlet opening of the reaction chamber, as in the example according to Fig. 1 and Fig. 3; the cover, among other things, facilitates the circulation of the cooling fluid.

In the example shown in the figures, the cover is substantially hemispherical and there is a supplying element (2, 21A, 21B) projecting from that at the top. Alternatively, the cover could be advantageously lengthened or sharpened, namely in an ogival shape, in the direction of the reaction chamber and with no supplying elements projecting.

Advantageously, the openings in the shell are formed on the side of the shell opposite to the cover, as in the example according to Fig. 1; this arrangement facilitates the circulation of the cooling fluid; moreover, it keeps the cooling fluid inlet and outlet far from the wall of the reaction chamber which, during the epitaxial deposition processes, is very hot.

In order to facilitate and render more regular the circulation of the cooling fluid inside the shell, it is possible to envisage a circulation pipe which is connected to the inlet opening and which extends inside the shell into the cavity from the inlet opening preferably as far as the cover, as the pipe 36,shown in the example according to Fig. 1.

Advantageously, such a circulation pipe 36 surrounds the supplying pipe 2 of the device, and it is preferable coaxial with the this; such a feature is not shown in the figures.

Alternatively, for example, it is possible to envisage, inside the shell, at least one partition which extends substantially over the entire shell length; this alternative is slightly less convenient to realize because it is required to insert and fix, for example by means of welding, the partition inside the shell.

It is advantageous if the circulation pipe extends also outside the shell; in this way it is possible to join together piping of the conventional type in a zone far from the reaction chamber.

The supply pipe projects from the cooling member, in particular from the shell, preferably by a small amount on one side and by a large amount on a second side; the first side will be that close to the wall of the reaction chamber when the device is mounted inside the reactor. In this way, the gas which flows inside the pipe may be kept cold until a short time before entry into the reaction chamber, the shell is slightly spaced from the wall of the reaction chamber and therefore heats up slightly less and the connection to the usual piping of the reactor is situated well away from the reaction chamber. The distance of projection from the first side may be, for example, 10 mm to 20 mm; the distance of projection from the second side may be, for example, 100 mm to 200 mm, taking into account that the shell may be, for example, 100 mm to 200 mm long.

It is necessary to take into account the fact that the components of the device are close to parts of the reactor which have a very high temperature (depending on the cases, the reaction chamber, and therefore its walls also, may reach temperatures ranging from 600°C to 2,500°C).

It is also necessary to remember that the device in many of its embodiments including the one shown in Fig. 1, has a structure which is fairly simple, but such as to be made of metal by means of the welding of mechanically precision-machined parts; manufacture using quartz or graphite would be somewhat complicated.

On the basis of these two considerations, the supply pipe and/or circulation pipe and/or the shell is advantageously made of a metal chosen from the group composed of tantalum, niobium, molybdenum, tungsten, vanadium, chromium or a high-temperature chromium steel; these are high temperature resistant and chemical resistant materials.

As can be understood considering Fig. 3, the end of the supply pipe 2 which projects from the cooling member close to the wall 41 of the reaction chamber 40 is the part of the device which is subject to the highest degree of heating. Another part which is very much exposed to heating is the cover of the shell 3; however, the cover receives the heat, mainly by means of irradiation, on its outer surface and releases heat to the cooling fluid on its inner surface.

On the basis of these two considerations, it was thought to provide a nozzle able to convey the reaction gas towards the inlet into the reaction chamber and mounted on one end of the supply pipe (the end able to be positioned close to the inlet into the reaction chamber) and/or on the shell downstream of the supply pipe. The drawings in Fig. 2 show two possible ways of implementing this teaching. In this way, the nozzle may be made of a material which is highly refractory and inert, preferably graphite or quartz, without constructional problems; if graphite is used, this may be coated, if necessary, with a layer, for example, of silicon carbide or tantalum carbide. Moreover, if spurious depositions of material form on the nozzle, the latter may be easily replaced at little cost; the "dirty" nozzle may be cleaned or discarded.

As already mentioned, the present invention relates to an epitaxial reactor.

In general, this epitaxial reactor is equipped with a reaction chamber; moreover, it comprises an injection device and means able to cause the flow of a reaction gas inside the supply pipe of the device so as to introduce the reaction gas into the reaction chamber.

As already mentioned, according to the present invention, the device is optimally used for a single reaction gas; this has proved to be particularly useful for reaction gases such as silanes, chlorosilanes and organosilanes which may be advantageously used as precursor gases in the processes for epitaxial deposition of silicon carbide; moreover, such a device can be advantageously used also for precursor gases of others semiconductor materials (for example, gallium nitride) highly temperature sensitive, as metal organic compounds (for example, gallium tri-methyl).

It is worth noting that the device will be typically used for injecting a gaseous mixture containing the reaction gas in combination, for example, with hydrogen and/or helium and/or argon and/or hydrochloric acid.

Typically, the reactor according to the present invention comprises means able to cause the flow of a cooling fluid inside the cavity of the device, in particular inside the circulation pipe.

It is advantageous to envisage that the device is housed inside at least one tube, as the tube 6 in the example according to Fig. 3; preferably the device, in particular the shell of the device, is not in contact with such a tube.

From a constructional point of view it is convenient if the axis of the device and the axis of such a tube are substantially parallel; if the two axes substantially coincide, as in the example according to Fig. 3, an axial symmetry which is advantageous in every sense is obtained, i.e. from a mechanical, thermodynamic and fluid dynamic point of view.

The tube mentioned above was designed to receive a gas flow; consequently, the reactor may envisage in this case, means able to cause the gas to flow inside the tube. The gases which may be used include hydrogen, helium, argon, hydrochloric acid or mixtures thereof.

This tube is subject in particular in its zone close to the reaction chamber to high temperatures; it is necessary to take into account that it could also be directly in contact with a wall of the reaction chamber, as the tube 6 in the example according to Fig. 3. It must therefore be made of a refractory material; owing to its simple shape, it is possible to use graphite or quartz, depending on the temperatures; if necessary, the graphite may be coated with a layer of inert and refractory material, preferably silicon carbide or tantalum carbide. For the zones distant from the reaction chamber, it is possible to use also materials which are less resistant to heat, such as the metals used for the injection device.

This tube typically communicates with the reaction chamber of the reactor, as the tube 6 in the example according to Fig. 3, in such a way that the gas flow ends up inside the reaction chamber.

Inside an epitaxial reactor, the reaction chamber is delimited by walls, at least one of these having an opening for entry of the reaction gases.

It is appropriate to position the injection device according to the present invention so that its supply pipe emerges in the vicinity of this opening; in the example according to Fig. 3, the pipe 2 emerges in the vicinity of the opening 42. Advantageously the supply pipe does not extend inside the reaction chamber; it is also advantageous if the pipe is not in contact with the walls of the reaction chamber; in this way, the pipe heats up less and spurious depositions along the said pipe are less likely.

The shape of the opening in the wall corresponding to the injection device is important for obtaining the best results. In the example according to Fig. 3 there is firstly a gradual reduction in the diameter of the opening (with a consequent increase in the speed of the gas flow), then a sudden increase in the diameter of the opening and finally a sharp increase in the diameter of the opening. The effect which is obtained is that of preventing or limiting spurious depositions in the region of the opening.

The effectiveness of the abovementioned tube (the tube 6 in the example of figure 3) is maximum if its end is closed by the wall of the reaction chamber; in this way, the gas flow which travels along this tube ends up inside the reaction chamber. One possibility is that of placing such a tube in direct contact with the wall of the chamber, as in the example according to Fig. 3. Another possibility is that of placing between such a tube and the wall a part made of a refractory and preferably inert material; if this part is made of a material which is also a heat-insulating material, such a tube may be made of a material which is less heat resistant.

The gas flow which travels along this tube may be used to cool the injector on the outside and, in particular, to cool the shell of the injector on the outside.

Moreover, the gas flow which travels along this tube may be used with great advantage to isolate thermally and/or physically the reaction gas (flowing out of the supply pipe of the injection device) from the surfaces which delimit the inlet opening in the wall of the reaction chamber; for this purpose, the diameter of this inlet opening is preferably greater than the diameter of the supply pipe.

This feature is present in the example according to Fig. 3; from this figure it can be understood that the gas flow which emerges from the tube 6 tends to be arranged around the gas flow which emerges from the pipe 2 and in this way prevents or makes it more difficult for the latter to come into contact with the walls of the opening 42. Moreover, any liquid or solid particles which might form shortly before or after the end of pipe 2 are conveyed towards the reaction chamber by the gas flow emerging from the tube 6 preventing or limiting the possibility of their being deposited on the walls of the opening 42; this effect is further increased by the reduction in the diameter of the opening 42 and the consequent increase in the speed of flow. The cooling effect imparted to the reaction gas by the injection device is advantageously combined with rapid heating immediately afterwards.

For this purpose, the reactor according to the present invention may comprise a heating cell downstream of the injection device; this cell is able to evaporate any liquid or solid particles due to dissociation of the reaction gas. Typically, if the reaction gas which flows inside the supply pipe of the injection device is a silane or a chlorosilane or an organosilane, liquid particles of silicon could form; in the presence of carbon, solid particles of silicon carbide could form.

This heating cell may be situated at the inlet opening of the reaction chamber and preferably inside the reaction chamber, as in the example according to Fig. 3; in this way it is possible to make use of the heat of the said chamber.

The dome 5 shown in Fig. 3 is substantially at the same temperature as the reaction chamber and receives the gas flows from the pipe 2 and from the tube 6; this gas rapidly heats up underneath the dome 5 before entering slowly into the actual reaction chamber; in this way any liquid or solid particles evaporate and in any case are prevented from entering into the reaction chamber. Heating of these gases is also assisted by the terminal part of the opening 42 which has a wide flow cross-section.

As previously said, it could be advantageous precool the cooling fluid, in particular gaseous nitrogen, for example by means of liquid nitrogen(therefore at a temperature lower than -190°C). To achieve this object, it can be expected that at least a part of the cooling fluid flows in a cooling pipe before entering in the device ; such a cooling pipe is advantageously dip into a cryogenic bath, namely liquid nitrogen. The flow rate of the cooling gaseous fluid can be checked for example by means a MFC (Mass Flow Controller) device. The cooling gaseous fluid temperature can be checked for example changing the value of the exchanged heat through the cooling pipe; in such a way, it is possible to obtain a gaseous nitrogen flow at every desired temperature between 0°C and -100°C (with the aid of the liquid nitrogen bathroom) and to cool silane that flows in the device supplying pipe, according to the present invention, thereby avoiding therein the silane condensation.

With the aid of the reactor described above it is possible to implement a method for introducing a reaction gas, in particular a silane or a chlorosilane or an organosilane, into a reaction chamber of an epitaxial reactor. The first - fundamental - step of this method consists in keeping, by means of cooling means, the reaction gas cold, preferably at a temperature less than 300°C before entry into the reaction chamber.

This temperature depends on the reaction gas used; for example in the case of organosilanes, this temperature must be particularly low, typically a few tens of degrees centigrade.

A second step, which is very advantageous, consists in heating by means of the heating means the reaction gas to a temperature higher than 1500°C, preferably higher than 1800°C, in the vicinity of the inlet into the reaction chamber; in this way, it is possible to evaporate/sublimate effectively any liquid/solid particles present in the gaseous flow.

If, between the cooling means and the heating means, the gas is subject to a high mean temperature gradient preferably between 300°C/cm and 600°C/cm, the probability of liquid or solid particles forming upstream of the inlet into the reaction chamber is very low, in particular for the reaction gases mentioned above.

Finally, it is advantageous to provide a first gas flow, comprising the reaction gas, and a second gas flow, comprising preferably hydrogen and/or helium and/or argon and/or hydrochloric aid, around the first gas flow in the vicinity of the inlet into the reaction chamber so as to isolate it thermally and/or physically.

## Claims

1. Epitaxial reactor (4) with a reaction chamber (40), comprising:
- a device (1) for introducing reaction gases into said reaction chamber (40), said device comprising a gas supply pipe (2);
- means able to cause a flow of a reaction gas inside said supply pipe (2) so as to introduce the reaction gas into said reaction chamber (40); and
- a cooling member (3) situated at one end of the supply pipe (2) and able to cool said supply pipe (2) and thereby the gas flowing inside it, **characterized in that** said supply pipe (2) does not extend inside said reaction chamber (40).

2. Reactor according to Claim 1, **characterized in that** it comprises a single pipe (2) supplying a single reaction gas.

3. Reactor according to Claim 1 or 2, in which the cooling member (3) comprises a shell (31, 32, 33) which surrounds one end of the supply pipe (2).

4. Reactor according to Claim 3, in which the shell (31, 32, 33) delimits a cavity (30) and comprises means (34, 35, 36) for allowing the entry into, circulation inside and flowing out of a cooling fluid from the cavity (30).

5. Reactor according to Claim 4, in which the cooling fluid is gaseous or liquid.

6. Reactor according to Claim 4 or 5, in which said means comprise an inlet opening (34) and an outlet opening (35), said openings being formed in the shell (31, 32, 33).

7. Reactor according to one of Claims 3 to 6, in which the shell (31, 32, 33) has the shape substantially of a cylinder (32) and in which the axis of the shell (31, 32, 33) and the axis of the supply pipe (2) are substantially parallel and preferably coincide substantially.

8. Reactor according to Claim 7, in which the shell (31, 32, 33) terminates on one side in a cover (31).

9. Reactor according to Claims 6 and 8, in which the openings (34, 35) are formed on the side (33) of the shell (31, 32, 33) opposite the cover (31).

10. Reactor according to Claim 6 or 7 or 8 or 9, **characterized in that** it comprises a circulation pipe (36) connected to the inlet opening (34) and extending inside the shell (31, 32, 33) into the cavity (30) from the inlet opening (34) preferably as far as the cover (31).

11. Reactor according to Claim 10, in which the circulation pipe (36) extends also outside the shell (31, 32, 33).

12. Reactor according to one of the preceding claims, in which the supply pipe (2) projects from the cooling member (3), in particular from the shell (31, 32, 33), by a small amount on a first side and by a large amount on a second side.

13. Reactor according to one of the preceding claims, in which a nozzle (21A, 21B) able to convey said gas and made preferably of graphite or quartz is mounted on one end of the supply pipe (2) and/or on the shell (31, 32, 33) downstream of the supply pipe (2).

14. Reactor according to one or more of the preceding claims, in which the supply pipe (2) and/or the circulation pipe (36) and/or the shell (31, 32, 33) is made of a metal chosen from the group composed of tantalum, niobium, molybdenum, tungsten, vanadium, chromium or a high-temperature chromium steel.

15. Reactor according to one of the preceding claims, in which said reaction gas is a silane or a chlorosilane or an organosilane.

16. Reactor according to one of the preceding claims, **characterized in that** it comprises means able to allow a flow of cooling fluid into the cavity (30) of the device (1), in particular inside the circulation pipe (36).

17. Reactor according to one of the preceding claims, in which the device (1) is housed inside at least one tube (6).

18. Reactor according to Claim 17, in which the device (1) is not in contact with the tube (6).

19. Reactor according to Claim 17 or 18, in which the axis of the device (1) and the axis of the tube (6) are substantially parallel and preferably coincide substantially.

20. Reactor according to Claim 17 or 18 or 19, **characterized in that** it comprises means able to allow a flow of gas inside the tube (6).

21. Reactor according to Claim 20, in which said means are able to allow a flow of hydrogen and/or helium and/or argon and/or hydrochloric acid inside the tube (6).

22. Reactor according to one of Claims 17 to 21, in which the tube (6) is made of quartz or graphite and in particular is coated with a layer of inert and refractory material, preferably silicon carbide or tantalum carbide.

23. Reactor according to one of Claims 17 to 22, in which the tube (6) communicates with the reaction chamber (40).

24. Reactor according to one of the preceding claims, **characterized in that** it comprises walls which delimit the reaction chamber (40), where one wall (41) of the chamber has an inlet opening (42) and where the supply pipe (2) of the device (1) emerges in the vicinity of said inlet opening (42).

25. Reactor according to Claim 24, in which one end of the tube (6) is closed by said wall (41).

26. Reactor according to Claim 24 or 25, in which the diameter of the inlet opening (42) is greater than the diameter of the supply pipe (2).

27. Reactor according to one of the preceding claims, **characterized in that** it comprises a heating dome (5) downstream of the device (1).

28. Reactor according to Claim 27, in which the heating dome (5) is situated in the vicinity of an inlet opening (42) of the reaction chamber (40) and preferably inside the reaction chamber (40).

29. Method for introducing a reaction gas into a reaction chamber (40) of an epitaxial reactor (4), said reaction gas being in particular a silane or a chlorosilane or an organosilane, **characterized by** the fact of cooling, by means of cooling means (3), the reaction gas to a temperature, in particular lower than 300°C, only before entry into the reaction chamber (40).

30. Method according to Claim 29, **characterized by** the fact of heating, by means of heating means (5), the reaction gas to a temperature higher than 1500°C, preferably higher than 1800°C, in the vicinity of the inlet into the reaction chamber (40).

31. Method according to Claim 30, **characterized in that**, between said cooling means (3) and said heating means (5), the gas is subject to a mean temperature gradient of between 300°C/cm and 600[deg.]C/cm.

32. Method according to Claim 29 or 30 or 31, **characterized by** the fact of providing a first gas flow comprising the reaction gas and a second gas flow comprising preferably hydrogen and/or helium and/or argon and/or hydrochloric acid, said second gas flow being provided around said first gas flow in the vicinity of the inlet into the reaction chamber (40).

## Patentansprüche

1. Epitaxialreaktor (4) mit einer Reaktionskammer (40), welcher folgendes umfasst:
- eine Vorrichtung (1) zur Einführung von Reaktionsgasen in die Reaktionskammer (40), wobei die Vorrichtung ein Gasbeschickungsrohr (2) umfasst;
- Mittel die in der Lage sind eine Strömung des Reaktionsgases innerhalb des Beschickungsrohrs zu verursachen (2), wodurch das Reaktionsgas in die Reaktionskammer (40) eingeführt wird; und
- ein Kühlelement (3), das an einem Ende des Beschickungsrohrs (2) gelegen ist und in der Lage ist das Beschickungsrohr (2) und **dadurch** das in dessen Inneren strömende Gas zu kühlen,
**dadurch gekennzeichnet, dass** das Beschickungsrohr (2) nicht in die Reaktionskammer (40) hineinreicht.

2. Reaktor gemäß Anspruch 1, **dadurch gekennzeichnet, dass** er eine einzelne Rohrleitung (2) umfasst, die ein einzelnes Reaktionsgas liefert.

3. Reaktor gemäß Anspruch 1 oder 2, bei dem das Kühlelement (3) eine Hülle (31, 32, 33) umfasst, die ein Ende des Beschickungsrohrs (2) umgibt.

4. Reaktor gemäß Anspruch 3, bei dem die Hülle (31, 32, 33) eine Kavität (30) begrenzt und Mittel (34, 35, 36) umfasst, die den Eintritt, die innere Zirkulation und das Ausströmen des Kühlmittels aus der Kavität (30) erlauben.

5. Reaktor gemäß Anspruch 4, bei dem das Kühlmittel gasförmig oder flüssig ist.

6. Reaktor gemäß Anspruch 4 oder 5, bei dem diese Mittel eine Einlassöffnung (34) und eine Auslassöffnung (35) umfassen und diese Öffnungen in der Hülle (31, 32, 33) gebildet sind.

7. Reaktor gemäß einem der Ansprüche 3 bis 6, bei dem die Hülle (31, 32, 33) im wesentlichen die Form eines Zylinders (32) aufweist und bei dem die Achsen der Hülle (31, 32, 33) und die Achsen der Beschickungsrohrleitung (2) im wesentlichen parallel und vorzugsweise im wesentlichen deckungsgleich sind.

8. Reaktor gemäß Anspruch 7, bei dem die Hülle (31, 32, 33) an eine Seite einer Abdeckung (31) anschließt.

9. Reaktor gemäß den Ansprüchen 6 und 8, bei dem die Öffnungen (34, 35) auf der Seite (33) der Hülle (31, 32, 33) gebildet sind, die der Abdeckung (31) gegenüber liegt.

10. Reaktor gemäß Anspruch 6, 7, 8 oder 9, **dadurch gekennzeichnet, dass** er eine Umlaufrohrleitung (36) umfasst, die an die Einlassöffnung (34) angeschlossen ist und sich innerhalb der Hülle (31, 32, 33) von der Einlassöffnung (34) in die Kavität (30) erstreckt, vorzugsweise bis zur Abdeckung (31).

11. Reaktor gemäß Anspruch 10, bei dem sich die Umlaufrohrleitung (36) auch außerhalb der Hülle (31, 32, 33) erstreckt.

12. Reaktor gemäß einem der vorangehenden Ansprüche, bei dem die Beschickungsrohrleitung (2) aus dem Kühlelement (3) und insbesondere aus der Hülle (31, 32, 33) in einem geringen Maß auf der ersten Seite und in einem großen Maß auf der zweiten Seite herausragt.

13. Reaktor gemäß einem der vorangehenden Ansprüche, bei dem eine Düse (21A, 21B), die in der Lage ist das Gas zu überführen und die vorzugsweise aus Graphit oder Quarz hergestellt ist, an einem Ende der Beschickungsrohrleitung (2) und/oder an der Hülle (31, 32, 33) stromabwärts der Beschickungsrohrleitung (2) montiert ist.

14. Reaktor gemäß einem oder mehreren der vorangehenden Ansprüche, bei dem die Beschickungsrohrleitung (2) und/oder die Umlaufrohrleitung (36) und/oder die Hülle (31, 32, 33) aus einem Metall hergestellt ist, das ausgewählt ist aus Tantal, Niobium, Molybdän, Wolfram, Vanadium, Chrom oder einem Hochtemperaturchromstahl.

15. Reaktor gemäß einem der vorangehenden Ansprüche, bei dem das Reaktionsgas ein Silan, ein Chlorosilan oder ein Organosilan ist.

16. Reaktor gemäß einem der vorangehenden Ansprüche, der
**dadurch gekennzeichnet ist, dass** er Mittel umfasst, die in der Lage sind eine Strömung des Kühlmittels in die Kavität (30) der Vorrichtung (1), insbesondere innerhalb der Umlaufrohrleitung (36), gestatten.

17. Reaktor gemäß einem der vorangehenden Ansprüche, bei dem die Vorrichtung (1) innerhalb mindestens einer Röhre (6) untergebracht ist.

18. Reaktor gemäß Anspruch 17, bei dem die Vorrichtung (1) nicht in Kontakt mit der Röhre (6) ist.

19. Reaktor gemäß Anspruch 17 oder 18, bei dem die Achsen der Vorrichtung (1) und die Achsen der Röhre (6) im wesentlichen parallel und vorzugsweise im wesentlichen deckungsgleich sind.

20. Reaktor gemäß Anspruch 17, 18 oder 19, der **dadurch gekennzeichnet ist, dass** er Mittel umfasst, die eine Strömung des Gases innerhalb der Röhre (6) gestatten.

21. Reaktor gemäß Anspruch 20, bei dem diese Mittel eine Strömung aus Wasserstoff und/oder Helium und/oder Argon und/oder Salzsäure innerhalb der Röhre (6) gestatten.

22. Reaktor gemäß einem der Ansprüche 17 bis 21, bei dem die Röhre (6) aus Quarz oder Graphit hergestellt ist und insbesondere mit einer Schicht aus inertem und hitzebeständigem Material, vorzugsweise Silikoncarbid oder Tantalcarbid, beschichtet ist.

23. Reaktor gemäß einem der Ansprüche 17 bis 22, bei dem die Röhre (6) mit der Reaktionskammer (40) kommuniziert.

24. Reaktor gemäß einem der vorangehenden Ansprüche, der **dadurch gekennzeichnet ist, dass** er Wandungen umfasst, die die Reaktionskammer (40) begrenzen, wobei eine Kammerwandung (41) eine Einlassöffnung (42) aufweist und wobei die Beschickungsrohrleitung (2) der Vorrichtung (1) in der Umgebung der Einlassöffnung (42) auftaucht.

25. Reaktor gemäß Anspruch 24, bei dem ein Ende der Röhre (6) durch die Wandung (41) geschlossen ist.

26. Reaktor gemäß Anspruch 24 oder 25, bei dem der Durchmesser der Einlassöffnung (42) größer ist als der Durchmesser der Beschickungsrohrleitung (2).

27. Reaktor gemäß einem der vorangehenden Ansprüche, der **dadurch gekennzeichnet ist, dass** er eine Heizkuppel (5) stromabwärts der Vorrichtung (1) umfasst.

28. Reaktor gemäß Anspruch 27, bei dem die Heizkuppel (5) in der Umgebung einer Einlassöffnung (42) der Reaktionskammer (40), und vorzugsweise innerhalb der Reaktionskammer (40) gelegen ist.

29. Verfahren zur Einführung eines Reaktionsgases in eine Reaktionskammer (40) eines Epitaxialreaktors (4), wobei das Reaktionsgas insbesondere ein Silan, ein Chlorosilan oder ein Organosilan ist, wobei das Verfahren durch die Kühlung des Reaktionsgases auf eine Temperatur, insbesondere geringer als 300°C, lediglich kurz vor Eintritt in die Reaktionskammer (40) durch Kühlmittel (3) **gekennzeichnet** ist.

30. Verfahren gemäß Anspruch 29, welches durch Erhitzen des Reaktionsgases auf eine Temperatur von mehr als 1.500°C, vorzugsweise mehr als 1.800°C, durch Heizmittel (5), in der Umgebung des Einlasses in die Reaktionskammer (40) **gekennzeichnet** ist.

31. Verfahren gemäß Anspruch 30, welches **dadurch gekennzeichnet ist, dass** zwischen den Kühlmitteln (3) und den Heizmitteln (5) das Gas einem mittleren Temperaturgradienten zwischen 300°C/cm und 600°C/cm unterworfen wird.

32. Verfahren gemäß Anspruch 29, 30 oder 31, welches durch Bereitstellung einer ersten Gasströmung, die das Reaktionsgas umfasst, und einer zweiten Gasströmung, die vorzugsweise Wasserstoff und/oder Helium und/oder Argon und/oder Salzsäure umfasst, **gekennzeichnet** ist, wobei die zweite Gasströmung rings um die erste Gasströmung in der Umgebung des Einlasses in die Reaktionskammer (40) bereitgestellt wird.

## Revendications

1. Réacteur épitaxial (4) avec une chambre de réaction (40), comprenant :
un dispositif (1) pour l'introduction des gaz de réaction dans ladite chambre de réaction (40), ledit dispositif comprenant un tuyau d'alimentation de gaz (2) ;
des moyens pouvant provoquer un écoulement d'un gaz de réaction à l'intérieur dudit tuyau d'alimentation (2) afin d'introduire le gaz de réaction dans ladite chambre de réaction (40) ; et
un élément de refroidissement (3) situé au niveau d'une extrémité du tuyau d'alimentation (2) et pouvant refroidir ledit tuyau d'alimentation (2) et ainsi le gaz s'écoulant à l'intérieur de ce dernier,
**caractérisé en ce que** ledit tuyau d'alimentation (2) ne s'étend pas à l'intérieur de ladite chambre de réaction (40).

2. Réacteur selon la revendication 1, **caractérisé en ce qu'**il comprend un seul tuyau (2) alimentant un seul gaz de réaction.

3. Réacteur selon la revendication 1 ou 2, dans lequel l'élément de refroidissement (3) comprend une coque (31, 32, 33) qui entoure une extrémité du tuyau d'alimentation (2).

4. Réacteur selon la revendication 3, dans lequel la coque (31, 32, 33) délimite une cavité (30) et comprend des moyens (34, 35, 36) pour permettre à un fluide de refroidissement l'entrée dans, la circulation à l'intérieur de et l'écoulement hors de la cavité (30).

5. Réacteur selon la revendication 4, dans lequel le fluide de refroidissement est gazeux ou liquide.

6. Réacteur selon la revendication 4 ou 5, dans lequel lesdits moyens comprennent une ouverture d'entrée (34) et une ouverture de sortie (35), lesdites ouvertures étant formées dans la coque (31, 32, 33).

7. Réacteur selon l'une quelconque des revendications 3 à 6, dans lequel la coque (31, 32, 33) a sensiblement la forme d'un cylindre (32) et dans lequel l'axe de la coque (31, 32, 33) et l'axe du tuyau d'alimentation (2) sont sensiblement parallèles et coïncident sensiblement de préférence.

8. Réacteur selon la revendication 7, dans lequel la coque (31, 32, 33) se termine sur un côté par un couvercle (31).

9. Réacteur selon les revendications 6 et 8, dans lequel les ouvertures (34, 35) sont formées sur le côté (33) de la coque (31, 32, 33) opposée au couvercle (31).

10. Réacteur selon la revendication 6 ou 7 ou 8 ou 9, **caractérisé en ce qu'**il comprend un tuyau de circulation (36) raccordé à l'ouverture d'entrée (34) et s'étendant à l'intérieur de la coque (31, 32, 33) dans la cavité (30) à partir de l'ouverture d'entrée (34) de préférence jusqu'au couvercle (31).

11. Réacteur selon la revendication 10, dans lequel le tuyau de circulation (36) s'étend également à l'extérieur de la coque (31, 32, 33).

12. Réacteur selon l'une quelconque des revendications précédentes, dans lequel le tuyau d'alimentation (2) fait saillie de l'élément de refroidissement (3), en particulier de la coque (31, 32, 33), selon une petite quantité sur un premier côté et selon une grande quantité sur un second côté.

13. Réacteur selon l'une quelconque des revendications précédentes, dans lequel une buse (21A, 21B) pouvant transporter ledit gaz et réalisée de préférence à partir de graphite ou de quartz est montée sur une extrémité du tuyau d'alimentation (2) et/ou sur la coque (31, 32, 33) en aval du tuyau d'alimentation (2).

14. Réacteur selon une ou plusieurs des revendications précédentes, dans lequel le tuyau d'alimentation (2) et/ou le tuyau de circulation (36) et/ou la coque (31, 32, 33) est réalisé avec un métal choisi dans le groupe comprenant le tantale, le niobium, le molybdène, le tungstène, le vanadium, le chrome ou un acier inoxydable au chrome à haute température.

15. Réacteur selon l'une quelconque des revendications précédentes, dans lequel ledit gaz de réaction est un silane ou un silane chloré ou un silane organique.

16. Réacteur selon l'une quelconque des revendications précédentes, **caractérisé en ce qu'**il comprend des moyens pouvant permettre un écoulement de fluide de refroidissement dans la cavité (30) du dispositif (1), en particulier à l'intérieur du tuyau de circulation (36).

17. Réacteur selon l'une quelconque des revendications précédentes, dans lequel le dispositif (1) est logé à l'intérieur d'au moins un tube (6).

18. Réacteur selon la revendication 17, dans lequel le dispositif (1) n'est pas en contact avec le tube (6).

19. Réacteur selon la revendication 17 ou 18, dans lequel l'axe du dispositif (1) et l'axe du tube (6) sont sensiblement parallèles et coïncident de préférence sensiblement.

20. Réacteur selon la revendication 17 ou 18 ou 19, **caractérisé en ce qu'**il comprend des moyens pouvant permettre un écoulement de gaz à l'intérieur du tube (6).

21. Réacteur selon la revendication 20, dans lequel lesdits moyens peuvent permettre un écoulement d'hydrogène et/ou d'hélium et/ou d'argon et/ou d'acide chlorhydrique dans le tube (6).

22. Réacteur selon l'une quelconque des revendications 17 à 21, dans lequel le tube (6) est réalisé à partir de quartz ou de graphite et en particulier est recouvert avec une couche de matériau inerte et réfractaire, de préférence du carbure de silicium ou du carbure de tantale.

23. Réacteur selon l'une quelconque des revendications 17 à 22, dans lequel le tube (6) communique avec la chambre de réaction (40).

24. Réacteur selon l'une quelconque des revendications précédentes, **caractérisé en ce qu'**il comprend des parois qui délimitent la chambre de réaction (40), où une paroi (41) de la chambre a une ouverture d'entrée (42) et où le tuyau d'alimentation (2) du dispositif (1) sort à proximité de ladite ouverture d'entrée (42).

25. Réacteur selon la revendication 24, dans lequel une extrémité du tube (6) est fermée par ladite paroi (41).

26. Réacteur selon la revendication 24 ou 25, dans lequel le diamètre de l'ouverture d'entrée (42) est supérieur au diamètre du tuyau d'alimentation (2).

27. Réacteur selon l'une quelconque des revendications précédentes, **caractérisé en ce qu'**il comprend un dôme chauffant (5) en aval du dispositif (1).

28. Réacteur selon la revendication 27, dans lequel le dôme chauffant (5) est situé à proximité d'une ouverture d'entrée (42) de la chambre de réaction (40) et de préférence à l'intérieur de la chambre de réaction (40).

29. Procédé pour introduire un gaz de réaction dans une chambre de réaction (40) d'un réacteur épitaxial (4), ledit gaz de réaction étant en particulier un silane ou un silane chloré ou un silane organique, **caractérisé par** l'étape consistant à refroidir, au moyen de moyens de refroidissement (3), le gaz de réaction à une température, en particulier inférieure à 300°C, uniquement avant l'entrée dans la chambre de réaction (40).

30. Procédé selon la revendication 29, **caractérisé par** l'étape consistant à chauffer, au moyen de moyens de chauffage (5), le gaz de réaction à une température supérieure à 1500°C, de préférence supérieure à 1800°C, à proximité de l'entrée dans la chambre de réaction (40).

31. Procédé selon la revendication 30, **caractérisé en ce que**, entre lesdits moyens de refroidissement (3) et lesdits moyens de chauffage (5), le gaz est soumis à un gradient de température moyen compris entre 300°C/cm et 600°C/cm.

32. Procédé selon la revendication 29 ou 30 ou 31, **caractérisé par** l'étape consistant à prévoir un premier écoulement de gaz comprenant le gaz de réaction et un second écoulement de gaz comprenant de préférence de l'hydrogène et/ou de l'hélium et/ou de l'argon et/ou de l'acide chlorhydrique, ledit second écoulement de gaz étant prévu autour dudit premier écoulement de gaz à proximité de l'entrée dans la chambre de réaction (40).
